# EUROPEAN PATENT APPLICATION

(11) **EP 4 049 944 A1**
(43) Date of publication of application: **31.08.2022**
(21) Application number: 19949992.2
(22) Date of filing: 25.10.2019
(51) Int. Cl.: B65G 1/00, H05K 13/00

(54) **STORAGE CONTAINER**

(71) Applicant: Fuji Corporation, Chiryu-shi, Aichi 472-8686 (JP)
(72) Inventor: ITO Akinobu, Chiryu-shi, Aichi 472-8686 (JP)
(74) Representative: Grünecker Patent- und Rechtsanwälte PartG mbB
(86) International application number: PCT/JP2019/042034
(87) International publication number: WO 2021/079520

(57) **Abstract**

A storage container includes a placement section, a guide section, an imaging device, an acquisition section, and a recognition section. The placement section is configured to be a section on which an article, which is used for a board work machine for performing predetermined board work on a board, is placed temporarily when the article is received. The guide section notifies of a placement position of the article which is disposed on the placement section. The imaging device is capable of imaging the guide section and the article placed on the placement section from above. The acquisition section acquires using the imaging device a first image which images an imaging region including at least a part of the guide section before an operator places the article on the placement section and a second image which images the same imaging region after the operator places the article on the placement section. The recognition section recognizes at least one of the placement position and an external dimension of the article which is placed on the placement section based on difference information between the first image and the second image which are acquired by the acquisition section.

## Description

### Technical Field

The present description discloses a technique for a storage container.

### Background Art

A conveyance system described in Patent Literature 1 includes a conveyance device for conveying a load, an imaging device for continuously imaging the load placed by the conveyance device, and a controller. The controller includes an abnormality identifying section and a memory section. The abnormality identifying section identifies an abnormal location by comparing a load with a reference area where the load is to be placed based on imaging information which is imaged by the imaging device. The memory section stores imaging information at a point in time when an abnormal location is identified by the abnormality identifying section and before and after that point in time. In addition, with a second method described in Patent Literature 1, an initial state of an external area outside the reference area is caused to be stored for detection of an abnormality by comparing the initial state with the current state.

### Patent Literature

Patent Literature 1: JP-A-2019-34801

### Summary of the Invention

### Technical Problem

However, the conveyance system described in Patent Literature 1 is intended to detect an abnormality in an external appearance of a load but is not intended to recognize at least one of a placement position and an external dimension of an article. Specifically speaking, the conveyance system described in Patent Literature 1 detects an abnormal state in which a part of a tag (label) affixed to a vinyl wrapping wrapped around a package is peeled off to stick out into an external area outside a reference area.

In view of these situations, the present description discloses a storage container which enables a recognition of at least one of a placement position and an external dimension of an article which is placed on a placement section where the article is placed temporarily when the article is received.

### Solution to Problem

The present description discloses a storage container including a placement section, a guide section, an imaging device, an acquisition section, and a recognition section. The placement section is configured to be a section on which an article, which is used for a board work machine for performing predetermined board work on a board, is placed temporarily when the article is received. The guide section notifies of a placement position of the article which is disposed on the placement section. The imaging device is capable of imaging the guide section and the article placed on the placement section from above. The acquisition section acquires using the imaging device a first image which images an imaging region including at least a part of the guide section before an operator places the article on the placement section and a second image which images the same imaging region after the operator places the article on the placement section. The recognition section recognizes at least one of the placement position and an external dimension of the article which is placed on the placement section based on difference information between the first image and the second image which are acquired by the acquisition section.

### Advantageous Effect of the Invention

As described above, the storage container includes the placement section, the guide section, the imaging device, the acquisition section, and the recognition section. As a result, the storage container can recognize at least one of the placement position and the external dimension of the article placed on the placement section.

### Brief Description of Drawings

Fig. 1 is a schematic diagram showing a configuration example of a board production facility.
Fig. 2 is a plan view showing an example of a state in which articles are accommodated in accommodation cases at an arrival section.
Fig. 3a is a front view showing an example of a storage container.
Fig. 3b is a plan view of the storage container shown in Fig. 3a.
Fig. 3c is a perspective view of the storage container shown in Fig. 3a.
Fig. 4 is a side view of the storage container shown in Fig 3c as viewed in a direction indicated by an arrow IV.
Fig. 5 is a block diagram showing an example of control blocks of the storage container.
Fig. 6a is a flowchart showing an example of a control procedure in a receiving operation of an article.
Fig. 6b is a flowchart showing an example of a control procedure in a delivery operation of an article.
Fig. 7 is a schematic diagram showing an example of a guide section for each type of an article disposed at a placement section.
Fig. 8a is a schematic diagram showing an example of a first image.
Fig. 8b is a schematic diagram showing an example of a second image corresponding to the first image in Fig. 8a.
Fig. 8c is a schematic diagram illustrating another example of a second image corresponding to the first image in Fig. 8a.

### Description of Embodiment

### 1. Embodiment

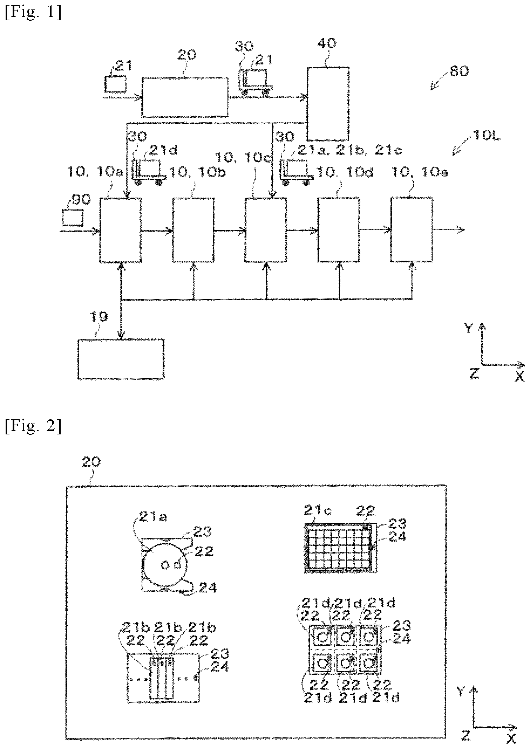

As shown in Fig. 1, storage container 40 of an embodiment of the present description is provided in board production facility 80. Board production facility 80 includes board working line 10L, arrival section 20, conveyance 30, and storage container 40.

### 1-1. Board Working Line 10L

In board working line 10L, predetermined board work is performed on board 90. The type and number of board work machines 10 making up board working line 10L are not limited. As shown in Fig. 1, board working line 10L of the present embodiment includes multiple (five) board work machines 10 including printer 10a, printing inspection machine 10b, component mounter 10c, reflow furnace 10d, and appearance inspection device 10e, and board 90 is conveyed sequentially in this order by a board conveyance device.

Printer 10a prints solder on multiple component mounting positions on board 90. Solder printed on board 90 has a predetermined viscosity, and the solder functions as a bonding material for bonding board 90 and components mounted on board 90 together. As shown in Fig. 2, solder container 21d accommodates solder. For example, a bottomed cylindrical or tubular sealable container can be used for solder container 21d.

Printing inspection machine 10b inspects a printing state of the solder printed by printer 10a. Component mounter 10c mounts multiple components on board 90 on which solder is printed. Component mounter 10c may be one, or multiple component mounters 10c may be provided. In the case that multiple component mounters 10c are provided, these multiple component mounters 10c can share mounting work of mounting multiple components on board 90.

Component mounter 10c includes a component supply device for supplying components which are to be mounted on board 90. The component supply device can supply components by using, for example, feeder 21b including reel 21a, tray 21c, and the like which are shown in Fig. 2. A component tape (carrier tape), which accommodates components therein, is wound around reel 21a. Reel 21a is rotatably and detachably provided on feeder 21b. A distal end portion of the component tape is drawn out to a component pickup or take-out section provided in feeder 21b, so that components are sequentially supplied.

Reel 21a can supply, for example, a relatively small component such as a chip component. Components are arranged in tray 21c. Tray 21c can supply relatively large components; for example, a Quad Flat Package (QFP), a Ball Grid Array (BGA), and the like. Reflow furnace 10d heats board 90 on which multiple components are mounted by component mounter 10c to melt the solder for soldering. Appearance inspection device 10e inspects a mounting state of the multiple components mounted on board 90 by component mounter 10c.

In this way, in board working line 10L, board 90 is conveyed sequentially, so that the production processes including the inspection process are performed thereon, whereby a board product can be produced using multiple (five) board work machines 10. Board working line 10L can include board work machines 10 such as a function inspection machine, a buffer device, a board supply device, a board flipping device, a shield mounting device, an adhesive application device, an ultraviolet ray irradiation device, and the like as required.

Multiple (five) of board work machines 10 making up board working line 10L and management device 19 are provided in such a manner as to communicate with each other by a wired or wireless communication section. Management device 19 controls multiple (five) board work machines 10, which make up board working line 10L, and monitors an operation situation of board working line 10L. Management device 19 stores various control data for controlling multiple (five) board work machines 10. Management device 19 transmits the control data to each of multiple (five) board work machines 10. In addition, each of multiple (five) board work machines 10 transmits an operation situation and a production situation to management device 19.

### 1-2. Arrival Section 20 and Conveyance Vehicle 30

When article 21 arrives at arrival section 20, predetermined landing work is performed. Then, article 21 is, for example, accommodated in accommodation case 23, is mounted on conveyance vehicle 30, and is conveyed to storage container 40. After having been stored in storage container 40, article 21 is then supplied to board working line 10L as required.

As has been described above, board working line 10L includes printer 10a. In this case, for example, solder container 21d which accommodates solder therein corresponds to article 21. Board working line 10L includes component mounter 10c. In this case, reel 21a, around which the component tape accommodating components thereon is wound, corresponds to article 21.

In addition, feeder 21b, on which reel 21a is rotatably and detachably provided, corresponds to article 21. Further, tray 21c, on which components are arranged, corresponds to article 21. A holding member for holding a component corresponds to article 21. The holding member includes, for example, a suction nozzle, a chuck, and the like. Furthermore, a holding member accommodating device (for example, a nozzle station) accommodating the holding member corresponds to article 21. As described above, article 21 need only be such as to be used for board work machine 10 configured to perform predetermined board work on board 90 and hence is not limited in any way.

Identification code 22 is provided on article 21. Identification code 22 stores identification information for identifying article 21. For example, a one-dimensional code, a two-dimensional code, a wireless tag, or the like can be used for identification code 22. When article 21 arrives at arrival section 20, the operator at arrival section 20 issues identification information using, for example, an article management device. In addition, the operator reads a barcode or the like provided on article 21 by a supplier (vendor) using a barcode reader or the like. Then, the operator can also acquire article information on article 21 from a database in which the article information for that article 21 is registered. The operator causes at least the identification information of the identification information and the article information to be stored in identification code 22 using the article management device.

The operator at arrival section 20 attaches identification code 22 which stores at least the identification information to article 21 and accommodates that article 21 in accommodation case 23. Accommodation case 23 need only accommodate at least one article 21 and hence can take various forms. Specific code 24 is provided in accommodation case 23. Specific code 24 stores specific information which identifies the accommodation case 23 to which the specific code 24 is so provided. For example, a one-dimensional code, a two-dimensional code, a wireless tag, or the like can be used for specific code 24.

When the operator accommodates article 21 in accommodation case 23, the operator reads specific code 24 using a reader and reads identification code 22 provided on the article 21 using the reader. As a result, a correspondence between the specific information which specifies accommodation case 23 which accommodates article 21 and the identification information identifying the article 21 is generated, and the correspondence so generated is transmitted to a memory section of management device 19 for storage therein.

The operator at arrival section 20 mounts accommodation case 23 accommodating article 21 on conveyance vehicle 30. Conveyance vehicle 30 can be pulled by, for example, the operator. For example, a self-propelled automated guided vehicle (AGV) can also be used for conveyance vehicle 30. Conveyance vehicle 30 of the present embodiment is an automated guided vehicle. Board working line 10L, arrival section 20, conveyance vehicle 30, ans storage container 40 are provided so as to communicate with each other by a wired or wireless communication section. When article 21 is mounted on conveyance vehicle 30, management device 19 transmits a conveyance command to conveyance vehicle 30. The conveyance command includes a conveyance destination of article 21. Management device 19 selects storage container 40 which can store the article 21 and determines on a conveyance destination therefor. When receiving the conveyance command, conveyance vehicle 30 conveys that article 21 to storage container 40 designated as the conveyance destination for that article 21.

Conveyance vehicle 30 can also convey article 21 without using accommodation case 23. In addition, the operator can also convey article 21 without using conveyance vehicle 30. Further, at least a part of the work described above as being performed by the operator can also be automated by use of a conveyance device (for example, a belt conveyor), an actuator (for example, a robot arm), an article management device, or the like.

### 1-3. Storage Container 40

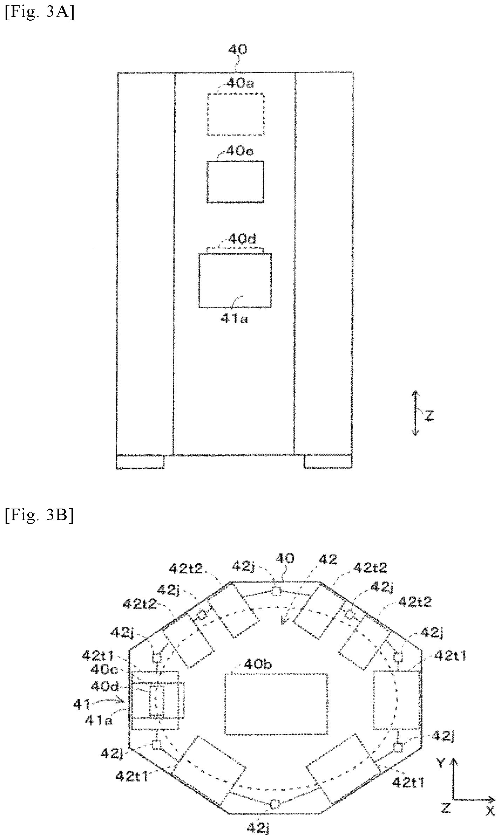

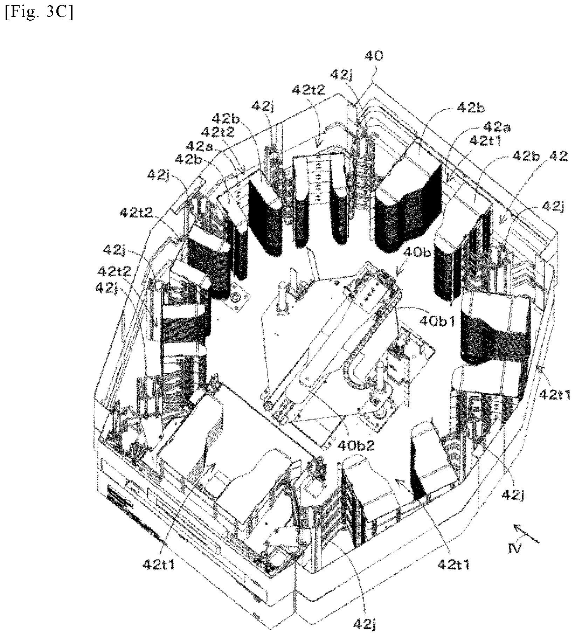

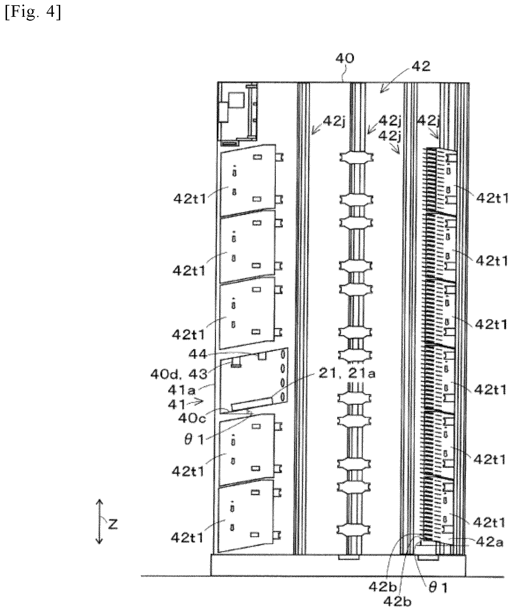

Storage container 40 need only be able to store articles 21 and hence can take various forms. As shown in Figs. 3a to 3c, storage container 40 according to the present embodiment has, for example, an octagonal prism-like shape. In Fig. 3c, storage container 40 is opened at an upper portion, so that the configuration of an inside of storage container 40 is visible. Fig. 4 is a schematic view of the inside of the storage container 40 as viewed from a direction indicated by an arrow IV shown in Fig. 3c, wherein a positional relationship between receiving section 41 and storage section 42 is mainly illustrated.

Storage container 40 includes receiving section 41, storage section 42, imaging device 43, control device 40a, and moving device 40b. Receiving section 41 includes opening section 41a and placement section 40c, and at least one guide section 52 is disposed at placement section 40c. Storage section 42 includes two types of storage units; a first storage unit 42t1 and second storage unit 42t2. Storage container 40 can include measurement device 44, and can also include reader 40d and display device 40e.

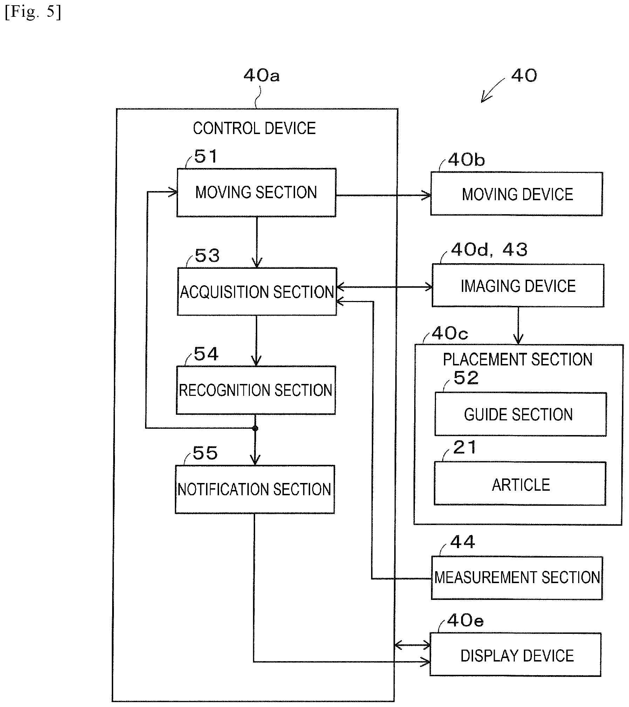

As shown in Fig. 5, when control device 40a is taken as being made up of control blocks, control device 40a includes moving section 51, acquisition section 53, and recognition section 54. Control device 40a can include notification section 55. As shown in Figs. 3a to 3c, 4 and 5, storage container 40 of the present embodiment includes all of the devices and parts that have been described above. Imaging device 43 doubles as reader 40d.

### 1-3-1. Schematic Configuration of Storage Container 40

Receiving section 41 includes opening section 41a and placement section 40c and receives at least article 21. As shown in Fig. 3a, opening section 41a is formed in a front surface of storage container 40. Article 21 is received in storage container 40 via opening section 41a. Opening section 41a of the present embodiment functions as a reception/delivery opening from which article 21 can be received in or delivered out, and article 21 can also be delivered out by way of opening section 41a. Opening section 41a is formed larger in size than article 21 so that article 21 can be received in and delivered out therethrough. In addition, a delivery port can also be formed in an opening section which differs from opening section 41a in storage container 40.

As shown in Figs. 3b and 4, placement section 40c is provided in a work space lying in the vicinity of opening section 41a. When article 21 is received in by way of opening section 41a, that article 21 is placed temporarily on placement section 40c. The operator executes a receiving operation of article 21 in which article 21 is conveyed in via opening section 41a and is then placed on placement section 40c. In addition, article 21, which is delivered out via opening section 41a, is placed on placement section 40c. As with the receiving operation, the operator executes a delivery operation of article 21 in which article 21 placed on placement section 40c is delivered out by way of opening section 41a.

As shown in Fig. 4, reader 40d is provided above placement section 40c. Reader 40d reads identification code 22 provided on article 21 to acquire identification information which identifies article 21. A known reader (for example, a code reader for reading one-dimensional code and a two-dimensional code, a wireless reader for performing a wireless communication with a wireless tag, or the like) can be used for reader 40d. When article 21 is received in by way of opening section 41a, reader 40d can read identification code 22 provided on that article 21 to acquire at least identification information of identification information and article information.

Storage section 42 stores article 21. Storage section 42 need only store article 21 and hence can take various forms. For example, in the case that article 21 is reel 21a, as shown in Figs. 3c and 4, storage section 42 need include main body section 42a and partition section 42b. Main body section 42a is formed into a U-shape when viewed in a vertical direction (a Z-axis direction). Partition section 42b is provided in such a manner as to protrude upwards at a predetermined angle with respect to main body section 42a and can store reel 21a. The angle of partition section 42b is set so as to prevent a fall of reel 21a.

In addition, for partition sections 42b for each storage unit, multiple pairs (in Fig. 4, 15 pairs/30) of partition sections 42b are provided, so that multiple (15) reels 21a can be stored. In each of the multiple pairs (15 pairs) of partition sections 42b, two partition sections 42b are provided in such a manner as to be spaced apart from each other so as not to interfere with moving device 40b. In Figs. 3c and 4, as a matter of convenience in illustration, reference signs are given to some of the members, and hence, reference signs are not give to all the members shown.

As shown in Figs. 3b and 3c, storage section 42 of the present embodiment is disposed in an elliptical shape when viewed in the vertical direction (the Z-axis direction). Storage section 42 of the present embodiment includes two types of storage units; first storage unit 42t1 and second storage units 42t2, and each of first storage unit 42t1 and second storage unit 42t2 includes multiple storage units which are provided along the vertical direction (the Z-axis direction). First storage unit 42t1 is formed wider than second storage unit 42t2, so that first storage unit 42t1 can store larger reel 21a than reel 21a that can be stored in second storage unit 42t2.

As shown in Figs. 3c and 4, first storage units 42t1 are coupled together in the vertical direction (the Z-axis direction) by coupling section 42j. In addition, second storage units 42t2 are coupled together in the vertical direction (the Z-axis direction) by coupling section 42j. Further, adjacent first storage units 42t1 are coupled together by coupling section 42j, and adjacent second storage units 42t2 are coupled together by coupling portion 42j. Furthermore, first storage unit 42t1 and second storage unit 42t2 which lie adjacent to each other are coupled together by coupling section 42j.

The types, numbers, and dispositions of the storage units can be changed as required. In addition, the shape and size (width, depth, and height) of the storage unit can be set in accordance with article 21 stored therein, and storage section 42 can store other articles 21 than reel 21a. Further, article 21 may be stored in any suitable storage unit, and in the case that board production facility 80 includes multiple storage containers 40, article 21 may be stored in any storage container 40, as long as storage container 40 includes a suitable storage unit for article 21.

Control device 40a includes an arithmetic unit and a storage device which are well know, and a control circuit is configured therein. Control device 40a is provided so as to communicate with moving device 40b, imaging device 43, which doubles as reader 40d, measurement device 44, and display device 40e and can control these devices. Control device 40a can store article information on article 21 and also can notify management device 19 of the article information. For example, in the case that article 21 is reel 21a, the article information can include type, number (residual number), diameter, thickness, model type and supplier (vendor), expiration date, and the like of components accommodated in reel 21a.

Moving device 40b moves article 21 received in receiving section 41 to storage section 42. Specifically speaking, moving device 40b moves article 21 placed on placement section 40c to storage section 42 in a receiving operation of article 21. In addition, moving device 40b can also move article 21 stored in storage section 42 to placement section 40c for the article 21 to be delivered out from storage container 40. As a result, the delivery operation of article 21 is enabled.

As shown in Figs. 3b and 3c, moving device 40b of the present embodiment is provided radially inwards of the storage unit (first storage unit 42t1 and second storage unit 42t2) when viewed in the vertical direction (the Z-axis direction). Moving device 40b need only be capable of moving article 21 and hence can take various forms. For example, a robot arm (an articulated robot), a lifting and lowering slide mechanism, and the like can be used for moving device 40b. For example, in the case that article 21 is reel 21a, as shown in Fig. 3c, moving device 40b need include lifting and lowering section 40b 1 and gripping section 40b2.

Lifting and lowering section 40b1 can rotate around an axis extending along the vertical direction (Z-axis direction) and can lift up and lower gripping section 40b2 along the vertical direction (the Z-axis direction). Gripping portion 40b2 can advance or retreat at the same angle as inclination angle θ1 of placement section 40c shown in Fig. 4. In addition, gripping section 40b2 can advance or retreat at the same angle as inclination angle θ1 of partition section 42b of storage section 42.

As described above, with storage container 40 of the present embodiment, inclination angle θ1 of placement section 40c and inclination angle θ1 of partition section 42b of storage section 42 coincide with each other. Thus, with storage container 40 of the present embodiment, an unloading operation at the time of reception which is performed when reel 21a is unloaded from placement section 40c and a storage operation at the time of reception which is performed when the reel 21a so unloaded is stored in storage section 42 can be executed by the lifting and lowering operation, rotational operation, and advancing and retreating operation of moving device 40b. In addition, with storage container 40 of the present embodiment, an unloading operation at the time of delivery, which is performed when reel 21a is unloaded from the storage unit, and a sending operation at the time of delivery, which is performed when the real 21a so unloaded is sent out to placement section 40c, can be executed by the lifting and lowering operation, rotational operation, and advancing and retreating operation of moving device 40b.

A known display device can be used for display device 40e, and display device 40e displays various types of data in such a way that the operator can visualize the data so displayed. Display device 40e displays, for example, article information on article 21 stored in storage section 42 or the like in response to an operation performed accordingly by the operator. Display device 40e of the present embodiment is made up of a touch panel, and display device 40e also functions as an input device for receiving various operations by the operator.

In addition, control device 40a can store positional information, reception and delivery information, and storage information on article 21 in storage section 42, and display device 40e can also display these pieces of information. The position information indicates a storage location of article 21. The reception and delivery information indicates the date and time of reception and data and time of delivery of article 21. The storage information includes, for example, information on an ambient temperature in storage section 42, a humidity in storage section 42, and the like. Control device 40a stores the positional information and data and time of reception of article 21 when the article 21 is stored. Control device 40a stores the storage information of article 21 while the article 21 is being stored in storage container 40. Control device 40a stores data and time of delivery of article 21 when the article 21 is delivered out from storage container 40.

### 1-3-2. Example of control for Reception and Delivery of Article 21

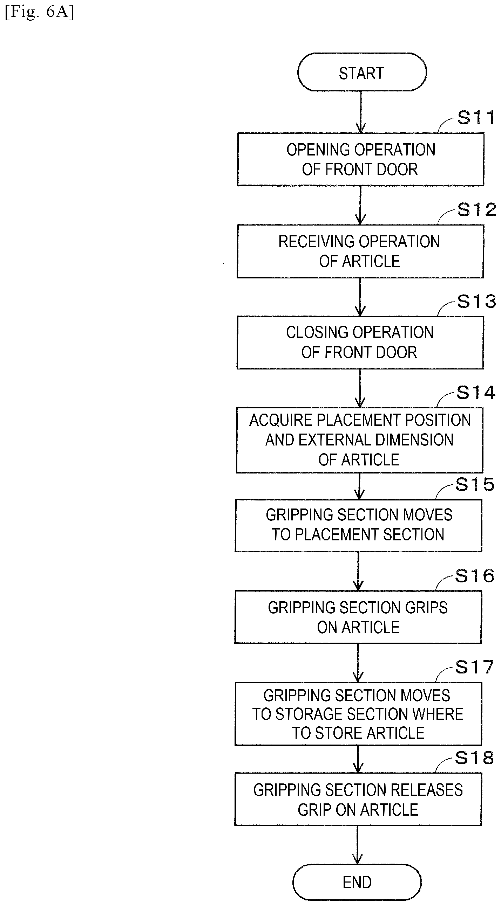

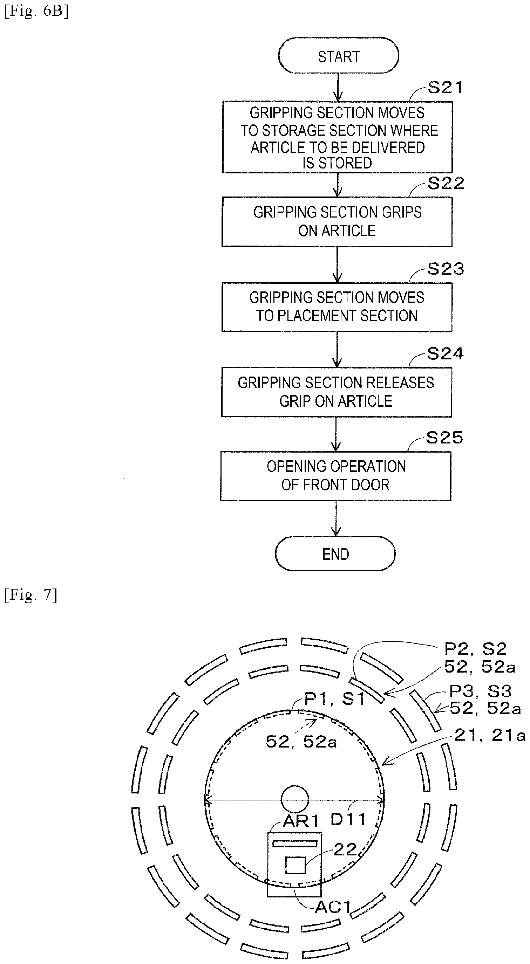

As shown in Fig. 5, when control device 40a is taken as being made up of control blocks, control device 40a includes moving section 51, acquisition section 53, recognition section 54, and notification section 55. Following flowcharts shown in Figs. 6a and 6b, control device 40a executes a control program. Fig. 6a shows an example of a control procedure for a receiving operation of article 21, and Fig. 6b shows an example of a control procedure for a delivery operation of article 21.

Moving section 51 moves article 21 placed on placement section 40c into storage section 42. Specifically speaking, moving section 51 moves article 21 placed on placement section 40c in a receiving operation of article 21 into storage section 42 by use of moving device 40b. In addition, moving section 51 can also move article 21 stored in storage section 42 to placement section 40c by use of moving device 40b when the article 21 is delivered out from storage container 40. Moving section 51 drives and causes moving device 40b to move article 21.

A front door is provided between opening section 41a and placement section 40c. For example, when moving device 40b has to operate currently or is scheduled to operate at a predetermined period of time at placement section 40c, control device 40a prohibits a receiving operation or a delivery operation of article 21 through opening section 41a. For this, control device 40a causes the front door to be kept in a closed state. On the contrary, when moving device 40b does not have to operate currently or is not scheduled to operate at a predetermined period of time at placement section 40c, control device 40a permits a receiving operation or a delivery operation of article 21 through opening section 41a. For this, control device 40a can cause the front door to be kept in an opened state.

When article 21 (for example, reel 21a) is received in, for example, the operator directs an opening operation of the front door using the touch panel (display device 40e functioning as the input device). When the receiving operation of article 21 is permitted, control device 40a performs the opening operation of the front door (step S11 shown in Fig. 6a). When the front door is put in the opened state, the operator places reel 21a in predetermined placement position P1 on placement section 40c via opening section 41a (step S12). When the receiving operation of reel 21a is finished, the operator notifies control device 40a that the receiving operation is finished using the touch panel. When it is notified of the end of the receiving operation, control device 40a performs a closing operation of the front door (step S13).

When the front door is caused to be put in a closed state, as will be described later, acquisition section 53 acquires second image PC2, and recognition section 54 recognizes at least one of placement position PI and external dimension S1 of reel 21a placed on placement section 40c (step S14). In addition, moving section 51 causes gripping section 40b2 of moving device 40b to move to placement section 40c (step S15). Specifically speaking, lifting and lowering section 40b1 of moving device 40b rotates as required and lifts up or lowers gripping section 40b2 along the vertical direction (the Z-axis direction) so that gripping section 40b2 reaches out reel 21a placed on placement section 40c when gripping section 40b2 advances. Next, gripping section 40b2 advances to grip reel 21a and then retreats in such a state that gripping section 40b2 holds a grip on reel 21a (step S16).

After the unloading operation at the time of reception described above, moving section 51 causes gripping section 40b2 to move to storage section 42 where to store reel 21a (step S17). Specifically speaking, lifting and lowering section 40b1 rotates as required and lifts up or lowers gripping section 40b2 along the vertical direction (the Z-axis direction) so that gripping section 40b2 reaches out a predetermined storage location (pair of partition sections 42b of first storage unit 42t1 or second storage unit 42t2) when gripping section 40b2 advances. Next, gripping section 40b2 advances to insert reel 21a into the storage location (pair of partition sections 42b), then, releases the grip on reel 21a, and retreats (step S18). As a result of the storage operation at the time of reception described above, reel 21a, which is article 21, is stored in storage section 42.

In the case that article 21 (for example, reel 21a) is delivered out, for example, the operator specifies reel 21a desired to be delivered out from storage container 40 using the touch panel. Moving section 51 causes gripping section 40b2 to move to storage section 42 where specified reel 21a is stored (step S21 shown in Fig. 6b). Specifically speaking, lifting and lowering section 40b1 rotates as necessary and lifts up or lowers gripping section 40b2 along the vertical direction (the Z-axis direction) so that gripping section 40b2 reaches out reel 21a stored in a desired storage location (pair of partition sections 42b) when gripping section 40b2 advances.

Next, gripping section 40b2 advances to grip reel 21a stored in the storage location (pairs of partition sections 42b) and retreats in such a state that gripping section 40b2 holds a grip on reel 21a (step S22). After the unloading operation at the time of delivery, moving section 51 causes gripping section 40b2 to move to placement section 40c (step S23). Specifically speaking, lifting and lowering section 40b1 rotates as required and lifts up or lowers gripping section 40b2 along the vertical direction (the Z-axis direction) so that reel 21a gripped by gripping section 40b2 reaches out placement section 40c when gripping section 40b2 advances.

Next, gripping section 40b2 advances to move reel 21a to placement section 40c, releases the grip on reel 21a, and retreats (step S24). When the sending operation at the time of delivery is finished, a rear door provided between placement section 40c and moving device 40b is closed. Then, control device 40a performs an opening operation of the front door, and the operator is allowed to perform a delivery operation of reel 21 by way of opening section 41a (step S25).

1-3-3. Example of Recognition of Placement Position PI and External Dimension S1 of Article 21

Storage container 40 includes, as described above, placement section 40c, guide section 52, imaging device 43, acquisition section 53, and recognition section 54. Guide section 52 notifies of placement position PI of article 21 disposed on placement section 40c. Guide section 52 need only notify of placement position PI and hence can take various forms. As shown in Fig. 7, guide section 52 of the present embodiment is band-shaped member 52a which is formed along a contour of article 21 when the article 21 is placed in placement position P1. For example, paint, a seal member, or the like can be used for band-shaped member 52a.

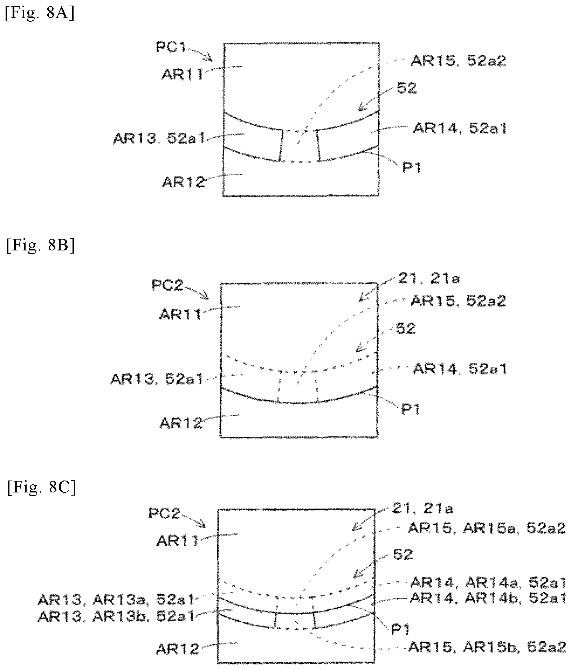

As shown in Figs. 8a to 8c, band-shaped member 52a includes first part 52a1 and second part 52a2 which are alternately arranged in a repeated fashion along a direction following the contour of article 21. First part 52a1 extends in a direction which follows along the contour of article 21 and is colored in a color which differs from that of placement section 40c. Second part 52a2 extends in the direction which follows along the contour of article 21 and is colored in a color which differs from that of first part 52a1. Second part 52a2 may be colored in a color which is the same as that of placement section 40c or may be colored in a color which differs from that of placement section 40c.

Article 21 of the present embodiment is reel 21a, and a main body portion of the reel 21a is colored in white in many cases. Therefore, placement section 40c of the present embodiment is colored in black in order for an outer edge section of reel 21a to be identified or recognized easily by providing a contrast between the outer edge section of reel 21a placed on placement section 40c and placement section 40c. There also exist reels 21a whose main body portion is colored in black Due to this, the color of band-shaped member 52a need be set so as to provide a contrast between the outer edge section of reel 21a placed on placement section 40c and first part 52a1 or second part 52a2. In the present embodiment, for example, first part 52a1 is colored in white, while second part 52a2 is colored in black. As a result, recognition section 54 can easily recognize the outer edge section of reel 21a.

Imaging device 43 need only be able to image guide section 52 and article 21 placed on placement section 40c from above, and hence, a known imaging device can be used for imaging device 43. As shown in Fig. 4, imaging device 43 of the present embodiment is fixed to a base plate above placement section 40c in such a manner that an optical axis thereof extends along the vertical direction. Imaging region AR1 shown in Fig. 7 shows an example of an imaging field of view of imaging device 43. Figs. 8a to 8c are enlarged views of imaging region AR1 shown in Fig. 7 produced by enlarging a portion in the vicinity of placement position P1.

Acquisition section 53 acquires first image PC1 and second image PC2 using imaging device 43. First image PC1 is an image which images imaging region AR1 including at least a part of guide section 52 before the operator places article 21 on placement section 40c. Second image PC2 is an image which images same imaging region AR1 after the operator places article 21 on placement section 40c. Acquisition section 53 sets an imaging condition of imaging device 43 for imaging of first image PC1 identical to an imaging condition of imaging device 43 for imaging of second image PC2. The imaging condition includes, for example, light source type, light irradiation direction, exposure time, diaphragm stop, and the like.

When imaging first image PC1, both the front door, which is provided between opening section 41a and placement section 40c, and the rear door, which is provided between placement section 40c and moving device 40b, are both caused to be put in the closed state. What is described above also applies similarly to imaging of second image PC2. In addition, acquisition section 53 acquires first image PC1 when article 21 is not placed on placement section 40c and there is no current work or no work scheduled for a predetermined period of time at placement section 40c. The current work or the work schedule for a predetermined period of time includes work using moving device 40b at placement section 40c. For example, it can be said that there exists work scheduled for a predetermined period of time when moving device 40b is moving to storage section 42 to unload article 21 therefrom for delivery.

First image PC1 does not have to be acquired every time the operator places article 21 on placement section 40c, and hence, first image PC 1 can be acquired in advance. In addition, as will be described later, acquisition section 53 can also acquire first image PC1 every time a predetermined period of time elapses. Further, acquisition section 53 can also acquire first image PC1 every time a state in which article 21 is not placed on placement section40c and there is neither current work nor work schedule for a predetermined period of time at placement section 40c occurs a predetermined number of times.

Recognition section 54 recognizes at least one of placement position PI and external dimension S1 of article 21 placed on placement section 40c based on difference information between first image PC1 and second image PC2 which are acquired by acquisition section 53. The difference information can be expressed by, for example, a change in color space of a pixel or pixels making up at least a part of multiple pixels in imaging region AR1. For example, in the case that each of the three primary colors of light is represented by 8 bits, black is represented by red, green, and blue which are all expressed as zero bit, while white is represented by red, green, and blue which are all expressed as 255 bits.

For example, let's assume a case in which a predetermined area of first image PC1 is black and the same predetermined area of second image PC2 is white. In this case, pixels in the predetermined area of first image PC1 are represented by a color space in which red, green, and blue are all expressed as zero bit. Pixels in the predetermined area of second image PC2 are represented by a color space in which red, green, and blue are all expressed as 255 bits. As a result, recognition section 54 can recognize a change in the predetermined area of imaging region AR1 (in this case, an occurrence of an event in which the color changes from black to white) by knowing a change in the color space of pixels in first image PC1 and second image PC2. What is described above about the color space also applies similarly to luminance, hue, color saturation, lightness, and the like.

In the present embodiment, the difference information is generated when the operator places article 21 in alignment with guide section 52, whereby at least a part of guide section 52 in imaging region AR1 is hidden by article 21. Fig. 8a shows an example of first image PC1. Region AR11 and region AR12 shown in Fig. 8a are regions where placement section 40c is imaged and are in black. Region AR13 and region AR14 are regions where first part 52a1 is imaged and are in white. Region AR15 is a region where second part 52a2 is imaged and is in black.

In the case that the operator places article 21 (reel 21a in the figure) in alignment with guide section 52, and the whole of guide section 52 in imaging region AR1 is hidden by article 21 (reel 21a), second image PC2 shown in Fig. 8b is obtained. However, the main body portion of reel 21a is referred to as, for example, white. In second image PC2 shown in Fig. 8b, region AR11, region AR13, region AR14, and region AR15 are in white, and region AR12 is in black. Thus, recognition section 54 gets to know difference information for region AR11 which images placement section 40c and region AR15 which images second part 52a2. In this case, recognition section 54 can recognize placement position PI of article 21 (reel 21a) placed on placement section 40c based on the difference information for region AR15 which images second part 52a2.

In addition, in the above example, for example, in the case that the main body portion of reel 21a is black, region AR11 to region AR15 all become black. Thus, recognition section 54 gets to know difference information for region AR13 and region AR14 which image first part 52a1. In this case, recognition section 54 can recognize placement position PI of article 21 (reel 21a) placed on placement section 40c based on the difference information for region AR13 and region AR14 which image first part 52a1.

Further, in the case that the operator places article 21 (reel 21a in the figure) in alignment with guide section 52, and a part of guide section 52 in imaging region AR1 is hidden by article 21 (reel 21a), second image PC2 shown in Fig. 8c is obtained. However, the main body portion of reel 21a is referred to as, for example, white. In second image PC2 shown in Fig. 8c, region AR11, region AR13, region AR14, and region AR15a are in white, whereas region AR15b and region AR12 are in black.

Region AR15a constitutes an area of region AR15 which is hidden by article 21 (reel 21a), and region AR15b constitutes an area of region AR15 which is exposed. Thus, recognition section 54 gets to know difference information for region AR11 which images placement section 40c and region 15a which images second part 52a2. In this case, recognition section 54 can recognize placement position P1 of article 21 (reel 21a) placed on placement section 40c based on the difference information for region 15a which images second part 52a2.

In addition, in the above example, for example, in the case that the main body portion of reel 21a is black, region AR11, region AR12, region AR13a, region AR14a, and region AR15 are in black, and region AR13b and region AR14b are in white. Region AR13a constitutes an area of region AR13 which is hidden by article 21 (reel 21a), and region AR13b is an area of region AR13 which is exposed. Region AR14a constitutes an area of region AR14 which is hidden by article 21 (reel 21a), and region AR14b constitutes an area of region AR14 which is exposed. Thus, recognition section 54 gets to know difference information for region AR13a and region AR14a which image first part 52a1. In this case, recognition section 54 can recognize placement position PI of article 21 (reel 21a) placed on placement section 40c based on the difference information for region AR13a and region AR14a which image first part 52a1.

Guide section 52 of the present embodiment is band-shaped member 52a formed along the contour of article 21 when article 21 is placed in placement position PI. In band-shaped member 52a, first part 52a1 and second part 52a2 are provided alternately in a repeated fashion in the direction along the contour of article 21. Thus, in either of the modes described above, recognition section 54 can recognize placement position PI of article 21 which is placed on placement section 40c based on the difference information for region AR13 and region AR14 which image first part 52a1 and the difference information for region AR 15 which images second part 52a2. What is described above also applies similarly to a case in which the main body portion of reel 21a is in a color other than white or black.

As shown in Fig. 7, guide section 52 can also notify of placement positions P1, P2, P3 of articles 21 which have different external dimensions S1, S2, S3, respectively. In this case, recognition section 54 can acquire external dimension S1 of article 21 corresponding to placement position PI of article 21 which recognition section 54 can recognize based on the difference information. Specifically speaking, the memory device of control device 40a stores the relationships between external dimensions S1, S2, S3 and placement positions P1, P2, P3 in an associated manner.

For example, in the case that recognition section 54 can recognize placement position PI of article 21 based on the difference information, recognition section 54 acquires external dimension S1 corresponding to placement position PI from the memory device. Similarly, in the case that recognition section 54 can recognize placement position P2 of article 21 based on the difference information, recognition section 54 acquires external dimension S2 corresponding to placement position P2 from the memory device. In addition, in the case that recognition section 54 can recognize placement position P3 of article 21 based on the difference information, recognition section 54 acquires external dimension S3 corresponding to placement position P3 from the memory device. In the case that article 21 is reel 21a, for example, external dimension S1 can be expressed by diameter D11 of reel 21a. What is described above also applies similarly to cases in which recognition section 54 acquires external dimension S2 and external dimension S3 of article 21.

Recognition section 54 can also recognize external dimension S1 of article 21 by image processing second image PC2. Specifically speaking, recognition section 54 acquires external dimension S1 of article 21 by image processing image data acquired by imaging device 43. The method of image processing is not limited, and a known method can be used. For example, recognition section 54 can acquire diameter D11 of reel 21a by measuring diameter D11 of reel 21a by recognizing the shape of an external appearance of the main body portion of reel 21a through image processing such as binarization.

In addition, a captured image of imaging region AR1 shown in Fig. 7 is an image of a part of reel 21a placed on placement section 40c, and an external edge of reel 21a so imaged is indicated by circular arc AC1. In this case, recognition section 54 cannot directly measure diameter D11 of reel 21a. As a result, recognition section 54 recognizes a part (circular arc AC1) of reel 21a and calculates diameter D11 of real 21a to thereby estimate diameter D11 of reel 21a. Specifically speaking, for example, recognition section 54 can calculate a radius of curvature of a circle indicating the outer edge of reel 21a based on the circular arc AC1 and can estimate diameter D11 of reel 21a.

In a mode in which the whole of guide section 52 in imaging region AR1 is hidden by reel 21a when the operator places reel 21a in alignment with guide section 52, guide section 52 is not imaged to be captured in second image PC2. Due to this, with the mode described above, a risk of guide section 52 being erroneously recognized as the outer edge section of reel 21a is reduced, whereby an erroneous recognition of external dimension S1 is reduced. In addition, in a mode in which a part of guide section 52 in imaging region AR1 is hidden by reel 21a, recognition section54 can recognize the external edge section of reel 21a in region AR13 and region AR14 which image first part 52a1 or region AR15 which images second part 52a2. Thus, in the mode described above, too, a risk of guide section 52 being recognized erroneously as the outer edge section of reel 21a is reduced, whereby an erroneous recognition of external dimension S1 is reduced.

Imaging device 43 of the present embodiment doubles as reader 40d for reading identification code 22 affixed to reel 21a. As a result, identification code 22 is included in imaging region AR1. Thus, recognition section 54 can acquire external dimension S1 of reel 21a when acquiring identification information which identifies reel 21a. With storage container 40 of the present embodiment, compared with a case in which imaging device 43 is provided separately, the size of the relevant device can be reduced, work space above placement section 40c can be made effective use of. What is described above also applies similarly to a case in which recognition section 54 recognizes external dimension S2 and external dimension S3 of article 21.

As shown in Fig. 3c, storage section 42 of the present embodiment includes two types of storage units; first storage unit 42t1 and second storage unit 42t2. First storage unit 42t1 is formed wider than second storage unit 42t2, so that first storage unit 42t1 can store larger reel 21a than reel 21a that can be stored in second storage unit 42t2. As described above, storage container 40 of the present embodiment includes multiple types (two types) of storage sections 42 which are each configured to store article 21 in accordance with external dimension S1 of article 21. In addition, moving section 51 moves article 21 placed on placement section 40c to storage section 42 using moving device 40b.

In this case, moving section 51 can select storage section 42 which matches external dimension S1 of article 21 which is recognized by recognition section 54 and move article 21 placed on placement section 40c to storage section 42 so selected. Specifically speaking, in the case that external dimension S1 of article 21 recognized by recognition section 54 matches first storage unit 42t1, moving device 51 selects first storage unit 42t1 as storage section 42 for article 21 placed on placement section 40c. Then, moving section 51 causes article 21 placed on placement section 40c to move to first storage unit 42t1 using moving device 40b.

Similarly, in the case that external dimension S1 of article 21 recognized by recognition section 54 matches second storage unit 42t2, moving section 51 selects second storage unit 42t2 as storage section 42 for article 21 placed on placement section 40c. Then, moving section 51 causes article 21 placed on placement section 40c to move to second storage unit 42t2 using moving device 40b. Thus, as described above, the type, number, and arrangement of the storage unit are not limited in any way.

When notification section 55 determines based on placement position PI of article 21 recognized by recognition section 54 that article 21 is placed in a position from which article 21 cannot be caused to move to storage section 42 using moving device 40b, notification section 55 notifies the operator of a correction of placement position PI of article 21. A permissible range of placement position PI can be acquired in advance by use of an actual device or machine or through a simulation for storage in the memory device of control device 40a. For example, a width dimension of band-shaped member 52a can also be set to a maximum value of the permissible range of placement position P1. In this case, when notification section 55 cannot recognize the outer edge section of article 21 (reel 21a) in the regions (region AR13, region AR14, and region AR15) of band-shaped member 52, notification section 55 can determine that article 21 is placed in a position from which article 21 cannot be caused to move to storage section 42 using moving device 40b.

In addition, for example, in the case that article 21, which is to be placed in placement position P1, is placed in another position (placement position P2 or placement position P3), notification section 55 can also notify the operator of a correction of placement position PI of article 21. Notification section 55 can notify the operator of a correction of placement position PI of article 21 using, for example, display device 40e shown in Fig. 3a. What is described above also applies similarly to a case in which notification section 55 notifies the operator of corrections of placement position P2 and placement position P3 of article 21.

In this way, recognition section 54 can recognize placement position PI of article 21 placed on placement section 40c based on the difference information between first image PC1 and second image PC2 which is acquired by acquisition section 53. In addition, recognition section 54 can also recognize an amount of positional deviation of placement position PI of article 21 placed on placement section 40c with respect to the predetermined position based on the difference information between first image PC1 and second image PC2 which are acquired by acquisition section 53. Further, recognition section 54 can recognize external dimension S1 of article 21 placed on placement section 40c based on the difference information between first image PC1 and second image PC2 which are acquired by acquisition section 53. That is, recognition section 54 can recognize at least one of placement position P1 and external dimension S1 of article 21 placed on placement section 40c based on the difference information between first image PC1 and second image PC2 which are acquired by acquisition section 53.

As described above, band-shaped member 52a can be formed of, for example, a paint, a sealing member, or the like. Thus, there is a possibility that the state of band-shaped member 52a gradually changes as a result of a contact between band-shaped member 52a with article 21, deterioration with age, and the like. In addition, there is a possibility that a deviation of the optical axis of imaging device 43 is generated. Due to this, in the case that acquisition section 53 does not update first image PC1, there is a possibility that accurate difference information between first image PC1 and second image PC2 cannot be acquired.

Then, acquisition section 53 need acquire first image PC1 every time a predetermined time elapses, and recognition section 54 need acquire difference information using latest first image PC1 acquired by acquisition section 53. The predetermined time can be set so as to match, for example, a change in the state of band-shaped member 52a and a maximum value of a permissible time during which the deviation of the optical axis of imaging device 43 or the like is allowed. In addition, acquisition section 53 can acquire first image PC1 when article 21 is not placed on placement section 40c and there exists neither current work nor work scheduled for a predetermined period of time at placement section 40c, and recognition section 54 can also acquire difference information using latest first image PC1 acquired by acquisition section 53.

Acquisition section 53 can acquire first image PC1 at a timing, for example, when a power supply is introduced. In addition, acquisition section 53 can also acquire first image PC1 every time a state in which article 21 is not placed on placement section 40c and there exists neither current work nor work scheduled for a predetermined period of time at placement section 40c occurs a predetermined number of times. In any of the cases, recognition section 54 can accurately acquire difference information between first image PC1 and second image PC2.

Whether article 21 is placed on placement section 40c can be determined by using, for example, a measurement result of measurement device 44. Measurement device 44 shown in Fig. 4 measures an external dimension of article 21 from above article 21 which is received in receiving section 41. A known measurement device such as an ultrasonic sensor, an optical sensor, a three-dimensional measurement device, or the like can be used for measurement device 44. In the case that an ultrasonic sensor is used as measurement device 44, measurement device 44 transmits and receives ultrasonic waves from above article 21 placed on placement section 40c. Specifically speaking, measurement device 44 transmits ultrasonic waves from a head provided above article 21 along the vertical direction (the Z-axis direction) with respect to article 21. Then, measurement device 44 receives ultrasonic waves reflected on article 21 by the head.

Measurement device 44 measures a time period from a transmission of ultrasonic wave to article 21 to a reception of ultrasonic wave which is reflected on article 21 to thereby measure a distance from the head to article 21. Then, measurement device 44 subtracts the measured distance from the head to article 21 from a distance from the head to placement section 40c which is acquired in advance and outputs a subtracted value (a distance difference) as a height dimension of article 21. Measurement device 44 can also measure a width dimension and a depth dimension of article 21 by sequentially moving the head above article 21 or by providing multiple heads.

In the case that article 21 is placed on placement section 40c, measurement device 44 outputs a height dimension of article 21. In the case that article 21 is not placed on placement section 40c, measurement device 44 outputs zero or a value close to zero. Thus, in the case that the height dimension of article 21 measured by measurement device 44 falls within an assumed height dimension range of article 21, acquisition section 53 can determine that article 21 is placed on placement section 40c. On the contrary, in the case that the height dimension of article 21 measured by measurement device 44 is extremely small (for example, zero) compared with an assumed height dimension of article 21, acquisition section 53 can determine that article 21 is not placed on placement section 40c.

### 1-4. Others

In the embodiment and the modified examples described heretofore, article 21 is described mainly as constituting reel 21a. However, article 21 may be, for example, feeder 21b, tray 21c, solder container 21d, the holding member, the holding member accommodating device, or the like. Storage container 40 can include a storage unit suitable for article 21 and can include a moving device suitable for article 21.

### 2. Example of Advantage of Embodiment

Storage container 40 includes placement section 40c, guide section 52, imaging device 43, acquisition section 53, and recognition section 54. As a result, storage container 40 can recognize at least one of placement position P1 and external dimension S1 of article 21 placed on placement section 40c.

### Reference Signs List

10: board work machine, 21: article, 40: storage container, 40b: moving device, 40c: placement section, 42: storage section, 43: imaging device, 51: moving section, 52: guide section, 52a: band-shaped member, 52a1: first part, 52a2: second part, 53: acquisition section, 54: recognition section, 55: notification section, 90: board, AR1: imaging region, PC1: first image, PC2: second image, P1, P2, P3: placement position, S1, S2, S3: external dimension.

## Claims

1. A storage container, comprising:
a placement section configured to be a section on which an article, which is used for a board work machine for performing predetermined board work on a board, is placed temporarily when the article is received;
a guide section configured to notify of a placement position of the article which is disposed on the placement section;
an imaging device configured to be capable of imaging the guide section and the article placed on the placement section from above;
an acquisition section configured to acquire, using the imaging device, a first image which images an imaging region including at least a part of the guide section before an operator places the article on the placement section and a second image which images the same imaging region after the operator places the article on the placement section; and
a recognition section configured to recognize at least one of the placement position and an external dimension of the article which is placed on the placement section based on difference information between the first image and the second image which are acquired by the acquisition section.

2. The storage container of claim 1,
wherein the difference information is generated when the operator places the article in alignment with the guide section and at least a part of the guide section in the imaging region is hidden by the article.

3. The storage container according to claim 1 or claim 2,
wherein the guide section notifies of the placement position of each of the articles having the different external dimensions, and
wherein the recognition section acquires the external dimension of the article corresponding to the placement position of the article which the recognition section can recognize based on the difference information.

4. The storage container according to claim 1 or claim 2,
wherein the recognition section image process the second image to thereby recognize the external dimension of the article.

5. The storage container according to any one of claims 1 to 4, comprising:
multiple types of storage sections configured to store the article matching the external dimension of the article; and
a moving section configured to move the article placed on the placement section to the storage sections using a moving device,
wherein the moving section selects the storage matching the external dimension of the article recognized by the recognition section and moves the article placed on the placement section to the storage section so selected.

6. The storage container according to any one of claims 1 to 4, comprising:
a storage section configured to store the article;
a moving section configured to move the article placed on the placement section to the storage section using a moving device; and
a notification section configured to notify the operator of a correction of the placement position of the article when the notification section determines based on the placement position of the article recognized by the recognition section that the article is placed in a position from which the article cannot be moved to the storage section using the moving device.

7. The storage container according to any one of claims 1 to 6,
wherein the guide section is a band-shaped member which is formed along a contour of the article when the article is placed in the placement position.

8. The storage container according to claim 7,
wherein the band-shaped member is such that a first part and a second part are provided alternately in a repeated fashion along a direction following the contour of the article, the first part extending in the direction following along the contour of the article and colored in a color which differs from that of the placement section, the second part extending in the direction following the contour of the article and colored in a color which differs from that of the first part.

9. The storage container according to any one of claims 1 to 8,
wherein the acquisition section acquires the first image every time a predetermined time elapses, and
wherein the recognition section acquires the difference information using the latest first image acquired by the acquisition section.

10. The storage container according to any one of claims 1 to 8,
wherein the acquisition section acquires the first image when the article is not placed on the placement section and there exists neither current work nor work scheduled for a predetermined period of time at the placement section, and
wherein the recognition section acquires the difference information using the latest first image acquired by the acquisition section.
